# EUROPEAN PATENT APPLICATION

(11) **EP 4 792 675 A1**
(43) Date of publication of application: **19.08.2026**
(21) Application number: 25158332.4
(22) Date of filing: 17.02.2025
(51) Int. Cl.: A24F 40/46, A24F 40/50, H03K 7/02, H03K 7/06, H03K 7/08, H02J 7/00, H02M 1/00, H02M 1/08, H02M 3/155, H05B 1/02, A24F 40/57

(54) **ELECTRICAL CIRCUITRY, AEROSOL-GENERATING SYSTEM, AND METHOD FOR CONTROLLING AN AEROSOL-GENERATING UNIT**

(71) Applicant: Imperial Tobacco Limited, Bristol BS3 2LL (GB)
(72) Inventor: HATTON, Kevin Paul, Bristol, BS3 2LL (GB)
(74) Representative: Mewburn Ellis LLP

(57) **Abstract**

This disclosure refers to an electrical circuitry (25) which is configured to implement pulse-width-modulation by switching the voltage supplied to the aerosol-generating unit (2) between a lower AGU voltage level and a higher AGU voltage level, wherein the electrical circuitry (25) includes a first switching element (50) configured to switch the voltage supplied to the aerosol-generating unit (2) between the lower AGU voltage level and the higher AGU voltage level depending on a control voltage, and a control circuit (25a) for generating the control voltage to be supplied to the first switching element (50), wherein the control circuit (25a) is configured, based on a switching signal of the pulse-width-modulation and/or frequency modulation, to switch between generating: a first control voltage and a second control voltage, and wherein the control circuit (25a) is further configured to change the first control voltage so as to modify the lower AGU voltage level.

## Description

### FIELD

The present disclosure relates to electrical circuitry for controlling an aerosol-generating unit of an aerosol-generating system. The electrical circuitry is configured to be connected to the aerosol-generating unit and to a power source for powering the aerosol-generating unit.

The present disclosure further refers to an aerosol-generating system which includes the electrical circuitry.

The present disclosure also relates to a method for controlling an aerosol-generating unit of an aerosol-generating system. The method comprises the step of controlling the aerosol-generating unit by controlling a power supply from a power source of the aerosol-generating system to the aerosol-generating unit.

### BACKGROUND

An electronic vapour product (EVP), also known as a vaping apparatus or a vape, is a type of aerosol-generating system in which an aerosol precursor (e.g. a liquid or gel) is aerosolised by an aerosol-generating unit, such as a heating element or ultrasonic element.

A heat-not-burn (HNB) device, also known as a heated tobacco device, is a type of aerosol-generating system in which an aerosol precursor (e.g., a solid precursor such as tobacco) is heated by a heating system to produce an aerosol that can be inhaled by the user.

Both types of aerosol-generating systems include an aerosol-generating unit which generates the aerosol from an aerosol-forming material. In some examples, the amount of aerosol that is generated from the aerosol-forming material depends on the power that is provided to the aerosol-generating unit.

It is against this background that the present invention has been developed.

### SUMMARY

In a first aspect, the present disclosure provides an electrical circuitry for controlling an aerosol-generating unit (AGU) of an aerosol-generating system. For powering the aerosol-generating unit, the electrical circuitry is configured to be connected to the aerosol-generating unit and to a power source. The electrical circuitry is configured to implement pulse-width-modulation and/or frequency modulation by switching the voltage supplied to the aerosol-generating unit between a lower AGU voltage level and a higher AGU voltage level.

In some examples, the first aspect may provide an electrical circuitry for controlling an aerosol-generating unit of an aerosol-generating system, wherein the electrical circuitry is configured to be connected to the aerosol-generating unit and to a power source for powering the aerosol-generating unit, wherein the electrical circuitry is configured to implement pulse-width-modulation and/or frequency modulation by switching a voltage supplied to the aerosol-generating unit between a lower AGU voltage level and a higher AGU voltage level, wherein the electrical circuitry is configured to modify the lower AGU voltage level supplied to the aerosol-generating unit and/or the higher AGU voltage level supplied to the aerosol-generating unit (e.g. in a manner described in more detail below).

Optionally, the electrical circuitry includes a first switching element and/or a control circuit for generating a control voltage to be supplied to the first switching element. Further optionally, the first switching element is configured to switch the voltage supplied to the aerosol-generating unit between the lower AGU voltage level and the higher AGU voltage level depending on a control voltage. In some examples, the control circuit is configured, based on a switching signal of the pulse-width-modulation and/or frequency modulation, to switch between generating: (a) a first control voltage configured to control the first switching element to supply the voltage of the lower AGU voltage level to the aerosol-generating unit, and (b) a second control voltage configured to control the first switching element to supply the voltage of the higher AGU voltage level to the aerosol-generating unit. Optionally, the control circuit is further configured to change the first control voltage so as to modify the lower AGU voltage level supplied to the aerosol-generating unit and/or the second control voltage so as to modify the higher AGU voltage level supplied to the aerosol-generating unit. These optional aspects of the electrical circuitry may be omitted, in some examples, with functional aspects of the electrical circuitry described below being implemented without necessarily using these optional aspects of the electrical circuitry.

In a second aspect, the present disclosure provides an aerosol-generating system which comprises an aerosol-generating unit configured to generate an aerosol from an aerosol-forming material, a power source for powering the aerosol-generating unit, and/or the electrical circuitry as described herein.

In a third aspect, the present disclosure provides a method for controlling an aerosol-generating unit of an aerosol-generating system, comprising the steps of (i) controlling the aerosol-generating unit by controlling a power supply from a power source of the aerosol-generating system to the aerosol-generating unit using pulse-width-modulation and/or frequency modulation, the voltage of a cycle of the pulse-width-modulation and/or frequency modulation is switched between a lower AGU voltage level and a higher AGU voltage level, and/or changing the lower AGU voltage level and/or the higher AGU voltage level unit during the pulse-width modulation and/or frequency modulation.

In a fourth aspect, the present disclosure provides a computer program comprising instructions which, when the program is executed by a computer, cause the computer to carry out the steps of the method as described herein.

In a fifth aspect, the present disclosure provides a computer-readable storage medium comprising instructions which, when executed by a computer, cause the computer to carry out the steps of the method as described herein.

The variation or modification of the lower AGU voltage level and/or the higher AGU voltage level allows to reduce a depth of modulation which may be considered as corresponding to the difference between the lower AGU voltage level and the higher AGU voltage level. The depth of modulation may refer to the amplitude of the voltage supplied to the aerosol-generating unit, e.g. the amplitude between the lower AGU voltage level and the higher AGU voltage level. For example, the modification of the lower AGU voltage level and/or the higher AGU voltage level may reduce the depth of modulation. This may reduce the wear of the power source and/or prolong the lifetime of the power source. Further, a reduced depth of modulation may deliver a smoother power output to the aerosol-generating unit.

This technical advantage becomes more apparent in comparison with existing aerosol-generating systems. Current aerosol-generating systems often use pulse-width-modulation (PWM) to switch the voltage of the power source from 100% on to 100% off. Power sources, such as Li-ION batteries, can be considered similar to mechanical devices in the sense that they wear out faster with heavy use. The depth of modulation can determine the cycle count of the power source. The smaller the depth of modulation (low DoM), the longer the power source could last. This disclosure relates to altering the depth of modulation during the active session to prolong the life of the power source. The lower AGU voltage level and the higher AGU voltage level may be modified during the generation of the switching signal, e.g. during a smoking session. The modification of the lower AGU voltage level and the higher AGU voltage level might not occur between the two smoking sessions, e.g. when no switching signal is generated. In other words, the control circuit may be configured to modify the first control voltage and/or the second control voltage at the same time as the switching signal is generated. The switching signal and the modification of the first control voltage and/or the second control voltage may be simultaneously executed.

Another advantage of the modulation of the lower AGU voltage level and/or the higher AGU voltage level can be an improved control of the aerosol-generating unit. With known aerosol generating systems, the power delivered to the aerosol-generating unit is solely controlled by changing the pulse width (with PWM) or the pulse frequency (with frequency modulation, "FM"). With the techniques described herein, the amplitude may be additionally modified which allows a more precise and/or faster control of the aerosol-generating unit, which may result in a more accurate control of the temperature of a heater which is an example of the aerosol-generating unit. This may be achieved in that pulses of the PWM or the FM do not need to be modulated as much with commonly known techniques. Rather, the additional modulation of the amplitude provides a further means for adjusting the power to be delivered to the aerosol-generating unit.

Switching between the lower AGU voltage level and the higher AGU voltage level is often provided by a field-effect transistor (FET) (an example of the first switching element) which is a type of transistor that uses an electric field to control the current through a semiconductor. FETs often have relatively high self-capacitance. This means that reducing the depth of modulation of a PWM or FM signal input reduces the time needed for the FET to respond (i.e., charge/discharge) to the voltage/current swings of the signal within a cycle. It is also expected to provide a reduction in heating of the circuitry inherent in driving high-frequency alternating-current (AC) signals through circuit components possessing high internal capacitances.

Examples of the aerosol-generating system may be an electronic vapour product (EVP) or a heat-not-burn (HNB) device as described in the background section. The aerosol-generating system is configured to generate an aerosol from an aerosol-forming material which may be included, contained, and/or provided by an article.

The term "aerosol-forming material" may refer to a substrate or formulation capable of releasing volatile components that can form an aerosol, e.g. by releasing volatile compounds in the aerosol-forming material. An "aerosol" is a dispersion of solid particles and/or liquid droplets dispersed in a gas. The aerosol may be visible or invisible. The aerosol-forming material may be referred to as "e-liquid". Typically, the aerosol-forming material includes a base liquid and optionally nicotine and/or flavourings such that the resulting aerosol contains nicotine and/or flavourings.

The aerosol-forming material may comprise solid (non-liquid) material, such plant material.

The plant material may comprise or be formed of tobacco.

The aerosol-generating system may be a two-part construction comprising a device body and the article (alternatively referred to as a "pod" or "cartomizer") configured to be releasably connected/disconnected by an end user. The device body and article are each configured to house respective components of the aerosol-generating system.

In some examples, the article may be configured to be disposed of upon depletion of aerosol-forming material from the storage portion, in which case the article may referred to as a "consumable". Alternatively, the article may be configured for reuse, such that it is configured to be refillable upon depletion of the aerosol-forming material from the storage portion.

In some examples, the article includes the aerosol-generating unit, e.g. the aerosol-generating unit is arranged in or on the article. In this case, the device body may be configured to supply power to the article. The aerosol-generating unit may be configured to aerosolize a liquid or solid aerosol-forming material stored or contained with the article. The article may be pod and the device body may be an EVP device.

In other examples, the device body include the aerosol-generating unit, e.g. the aerosol-generating unit is arranged in or on the device body. In this case, the article may be attached to the device body, e.g. to the aerosol-generating unit for the generation of the aerosol. The aerosol-generating unit may be configured to aerosolize a solid aerosol-forming material stored or contained with the article. The article may be a stick and the device body may be an HNB device.

The aerosol-generating unit may include a heating system to generate an aerosol from the aerosol-forming material. The heating system which can penetrate the article (e.g. in case of an HNB device). Alternatively, the heating system is configured to generate an aerosol from a liquid aerosol-forming material held in a storage portion of the aerosol-generating system (e.g. a tank of the aerosol-generating system).

The aerosol-generating unit may include non-heating systems, such as ultrasonic elements or atomizers, for generating the aerosol from the aerosol-forming material.

The electrical circuitry and/or the power source may be located in or on the device body, for example within a housing of the device body. The electrical circuitry and/or the power source may not be exposed on an outer surface of the aerosol generating system. The electrical circuitry may control the supply of electrical power from the power source to the aerosol-generating unit. Thus, the electrical circuitry, optionally the first switching element, may be connected between the power source and aerosol-generating unit.

The amount of aerosol that is generated from the aerosol forming material may depend on the power supplied to the aerosol-generating unit which may be controlled by the electrical circuitry. For example, the electrical circuitry is configured to maintain a constant power supply to the aerosol-generating unit, for example irrespective of the voltage and/or electrical energy stored in the power source. This may result in a constant temperature of the heating system of the aerosol-generating unit. Alternatively or additionally, the electrical circuitry is configured to vary the power supply to the aerosol-generating unit for varying the amount of aerosol that is generated by the aerosol-generating unit.

The electrical circuitry may be in data communication with an input device of the aerosol generating system. The input device may include a button, switch, and/or a communication device with which the aerosol-generating unit can be controlled by a user. For example, the user may start and/or stop the operation of the aerosol-generating unit via the input device. Alternatively or additionally, the user may change the amount of aerosol that is generated by the aerosol-generating unit using the input device.

Alternatively or additionally, the electrical circuitry may be in data communication with wireless interface or a pressure sensor. The pressure sensor may be configured to detect an airflow in the aerosol-generating system, e.g. caused by a puff of the user. The electrical circuitry may be configured to detect a puff of a user based on the detected airflow. The electrical circuitry may control the supply of power to the aerosol-generating unit based on a detected puff.

The wireless interface may include an antenna for wireless communication of an external device with the electrical circuitry. In this way, the external device may be used to adjust the amount of aerosol that is generated by the aerosol-generating unit, for example by adjusting the level of voltage supplied to the aerosol-generating unit..

The input device, the wireless interface, and/or the pressure sensor may be configured to send a control signal to the electrical circuitry which controls the aerosol generated generating unit based on the control signal.

The power source may include one or more (re-chargeable) batteries configured to supply electrical energy to operate the aerosol-generating unit and other components of the aerosol-generating system, such as the electrical circuitry. The aerosol-generating system may be powered, alternatively or in addition to the power source, by an external power source.

The electrical circuitry may include to one or more electrical components, examples of which may include: an Application Specific Integrated Circuit (ASIC); electronic/electrical componentry (which may include combinations of transistors, resistors, capacitors, inductors etc); one or more processors; a non-transitory memory (e.g. implemented by one or more memory devices), that may store one or more software or firmware programs; a combinational logic circuit; interconnection of the aforesaid. The electrical circuitry may be located entirely at the aerosol-generating system, or distributed between the device and/or on one or more external devices in communication with the device, e.g. as part of the system.

The electrical circuitry may include a processing resource (or processor or controller) which may refer to one or more units for processing data, examples of which may include an ASIC, microcontroller, FPGA, microprocessor, digital signal processor (DSP) capability, state machine or other suitable component. A processing resource may be configured to execute a computer program, e.g. which may take the form of machine readable instructions, which may be stored on a non-transitory memory and/or programmable logic. The processing resource may have various arrangements corresponding to those discussed for the circuitry, e.g. on-board and/or off board the device as part of the system. As used herein, any machine executable instructions, or computer readable media, may be configured to cause a disclosed method to be carried out, e.g. by an aerosol-generating system as disclosed herein, and may therefore be used synonymously with the term method.

The electrical circuitry may include one or more switching elements, including the first switching element, a second switching element, and/or third switching element (explained in more detail further below).

In some examples, the processing resource controls the supply of electrical energy from the power source to the aerosol-generating unit. For example, the processing source controls one or more switching elements of the electrical circuitry. The one or more switching elements may each include a FET, such as a junction FET (JFET) and metal-oxide-semiconductor FET (MOSFET). The electrical circuitry may further include one or more resistors, one or more capacitors, and/or one or more inductors which may be electrically connected to the one or more switching elements. The processing resource may be configured to control the one or more switching elements, for example whether the switching element is in a fully open (conducting) state, in the fully closed (non-conducting) state, or in states between the fully open and the fully closed state. For example, the processing resource may control a voltage that is supplied to the switching element, for example to a gate of the switching element. Based on the voltage supplied to the switching element, the switching element opens from the fully closed (non-conducting) state to the fully open (conducting) state. In this way, the processing resource may control and/or change the higher AGU voltage level and the lower AGU voltage level.

The electrical circuitry, optionally the processing resource, is configured to generate the switching signal for controlling the conducting state of the first switching element. The switching signal may include the information on the conducting state of the first switching element as a voltage that is supplied to first switching element. The switching signal may switch between an upper switching voltage level and a lower switching voltage level.

For example, a voltage of zero, i.e. no voltage, supplied to the first switching element may put the first switching element in a closed or non-conducting state. A voltage of the second control voltage greater than zero that is supplied to the first switching element may put the first switching element in a fully or partially open state. If the voltage supplied to the first switching element is between 0 V (zero voltage) and the second control voltage, the first switching element may be set to be between the non-conducting state and the fully conducting state. For example, the first switching element may allow 50% of the voltage across the first switching element.

The first control voltage and the second control voltage are examples of a control voltage that is supplied to the first switching element for controlling the conducting state of the first switching element. The first control voltage and the second control voltage may respectively correspond to an upper or lower level of a control signal supplied to the first switching element for controlling the conducting state of the first switching element. A difference between first control voltage and the second control voltage may correspond to an amplitude of the control signal. The control circuit is configured to generate the control signal. For example, the control circuit may be configured to generate the control signal by selectively modifying or not modifying the switching signal.

The control signal may be a square wave or includes various pulses. Of course, other shapes of the control signal are possible. The control signal may describe the temporal behaviour of a voltage supplied to the first switching element.

The first control voltage and the second control voltage may be supplied to the gate of the first switching element. A first port of the first switching element (e.g. a source of the FET) may be connected to the power source and a second port of the first switching element (e.g. a drain of the FET) is connected to the power source, or vice versa.

The switching signal and/or the control signal may correspond to voltage data. For example, the control signal may be supplied to a gate of the first switching element and/or the switching signal may be supplied to the control circuit. The first control voltage and the second control voltage may correspond to two states of the control signal or to two states of switching signal that are modified by the control circuit. The level of the voltage (e.g. the level of the first control voltage and/or the second control voltage) supplied to the first switching element can be used to control the conducting state of the first switching element.

As commonly known, pulse-width modulation (PWM), also known as pulse-duration modulation (PDM) or pulse-length modulation (PLM), is a method of controlling power supply to the aerosol-generating unit as a rectangular wave with a varying duty cycle. PWM can be useful for controlling the average power to the aerosol-generating unit. The average value of voltage (and current) fed to the load (e.g. the aerosol-generating unit) is controlled by switching the supply between the lower AGU voltage level and the higher AGU voltage level of the voltage of the power source (e.g. 0 and 100% of the voltage of the power source, respectively) at a rate faster than it takes the load to change significantly. This would be the situation with the aerosol-generating system if the control circuit was not present, i.e. the switching signal was not modified or changed by the control circuit. In other words, the control circuit provides a variation or modification of the lower AGU voltage level and/or the higher AGU voltage level even if the switching signal is not changed or modified, for example the processing resource outputs the switching signal with constant amplitude.

The switching signal may control the temporal behaviour of the first control voltage and the second control voltage and the control circuit is configured to vary or modify the amplitude of the switching signal and/or the voltage levels of the switching signals. Optionally, the control circuit does not modify or change the temporal behaviour of the switching signal. In other words, the control circuit may not change the chronological or temporal sequence of the switching signal.

The PWM signal is an example of the switching signal that is used to control the first switching element in time domain. Further, the switching signal may be a rectangular wave whereby the upper and lower levels of the rectangular wave may correspond to the second control voltage and the first control voltage, respectively, if the control circuit does not modify the switching signal. Optionally, the maximum voltage level or the upper switching voltage level of the switching signal corresponds to the second control voltage and the minimum voltage level or the lower switching voltage level of the switching signal may correspond to the first control voltage if the control circuit does not modify the switching signal. For example, the first control voltage is 0 V which results in that the first switching element blocks the flow of current from the power source to the aerosol-generating unit. Similarly, the second control voltage may correspond to a maximum voltage that can be supplied to the first switching element which results in that the first switching element supplies to voltage of the power source to the aerosol-generating unit. The maximum voltage depends on the voltage that the first switching element requires to be in the fully conducting state.

Similarly, the aerosol-generating unit may be controlled by modifying the power supplied to the aerosol-generating unit using frequency modulation. In general, frequency modulation (FM) can be considered as encoding information in a carrier wave by varying the instantaneous frequency of the wave. For example, the controller using frequency modulation may be configured to generate pulses having a constant width or duration. With frequency modulation, the frequency of the pulses is modified for controlling the power supply to the aerosol-generating unit. This FM signal is an example of the switching signal.

The FM signal may include a plurality of rectangular pulses whereby the maximum and minimum levels of the rectangular pulses (e.g. the upper and lower switching voltage levels) correspond to the second control voltage and the first control voltage, respectively, if the control circuit does not modify the switching signal. More generally speaking, the maximum voltage level or the upper switching voltage level of the FM signal corresponds to the second control voltage and the minimum voltage level or the lower switching voltage level of the switching signal corresponds to the first control voltage if the control circuit does not modify the switching signal.

The PWM signal may have a duty cycle that is in the range between 50 µs to 200 ms, optionally between 1 ms and 100 ms. The control circuit might not change the duty cycle of the PWM signal. Similarly, the FM signal has a pulse width that can be in the range between 50 µs to 200 ms, optionally between 1 ms and 100 ms. The control circuit might not change the pulse width of the FM signal. As outlined above, the switching signal, optionally a PWM signal and/or the FM signal, may have a constant amplitude. This constant amplitude can be modified using the control circuit. The modified switching signal is the supplied to the first switching element as the first control voltage and the second control voltage. This means that the signal for controlling the switching element can be modified with regard to the amplitude (by the control circuit) and the duty cycle (with PWM modulation) or the frequency (with FM modulation).

An example of the frequency modulation is pulse-frequency modulation (PFM) which may be a modulation method for switching the respective signal using only two levels. For example, if the switching signal is based on the PFM, the switching signal swings between the first control voltage and the second control voltage. Unlike PWM, in which the width of square pulses is varied at a constant frequency, PFM fixes the width of square pulses while varying the frequency. In other words, the frequency of the pulse train is varied, for example in accordance with the power to be supplied to the aerosol-generating unit. The amplitude and width of the pulses of the switching signal can be kept constant with PFM.

The control circuit may be configured to modify the upper switching voltage level and/or or the lower switching voltage level of the PWM signal and/or the FM signal for generating the changed first control voltage and/or the second control voltage, respectively. In other words, the control circuit provides the option for selectively modifying the amplitude of the PWM signal and/or the FM signal.

The control circuit may be configured to only modify the minimum amplitude of the PWM signal and/or the FM signal. In this case, the control circuit may be configured to only modify the lower AGU voltage level. Similarly, the control circuit may be configured to only modify the maximum amplitude of the PWM signal and/or the FM signal. In this case, the control circuit is configured to only modify the higher AGU voltage level. In a further example, the control circuit may be configured to modify both the maximum amplitude and the minimum amplitude of the PWM signal and/or the FM signal. In this case, the control circuit is configured to modify both the higher AGU voltage level and the lower AGU voltage level.

The first voltage level and/or the second voltage level may be predetermined voltage levels. In this case, the electrical circuitry may be configured to output the first voltage level and/or the second voltage level as fixed voltage levels, for example independent of the voltage level of the power source. Alternatively, the first voltage level and/or the second voltage level may be relative voltage levels. This would mean that the first voltage level and/or the second voltage level may depend on the voltage level of the power source.

Optionally, the electrical circuitry may be configured to modify the first control voltage and/or the second control voltage by selecting the first control voltage and/or the second control voltage from a plurality of predetermined first control voltages and/or the second control voltages, respectively. For example, the control circuit is configured to select the modified or changed first control voltage from a plurality of predetermined first control voltages. In some examples, the control circuit is configured to select the modified or changed first control voltage from 2 to 10, optionally 2 to 5, different predetermined first control voltages. Similarly, the control circuit is configured to select the modified or changed second control voltage from a plurality of predetermined second control voltages. In some examples, the control circuit is configured to select the modified or changed first control voltage from 2 to 10, optionally 2 to 5, different predetermined second control voltages.

With these examples, the electrical circuitry may be configured to modify the lower AGU voltage level and/or the higher AGU voltage level from a plurality of predetermined lower AGU voltage levels and/or the higher AGU voltage levels, respectively. For example, the electrical circuitry may be configured to modify the lower AGU voltage level and/or the higher AGU voltage level from 2 to 10, optionally 2 to 5, different predetermined lower AGU voltage levels and/or the higher AGU voltage levels, respectively.

In some examples,, one of the unchanged first control voltage and the changed first control voltage may be configured to control the first switching element to supply a lower AGU voltage level of 0 V to the aerosol-generating unit and the other of the unchanged first control voltage and the changed first control voltage is configured to control the first switching element to supply a lower AGU voltage level in range of 5 % to 75 % of a voltage of the battery to the aerosol-generating unit.

In some examples, the lower AGU voltage level of the pulse-width modulation or the frequency modulation may be changed between 0 V and a voltage in range of 5 % to 75 % of a voltage of the power source or vice versa.

Optionally, the lower AGU voltage level can be or can be modified to be in a range from 25 % to 75 % or 25 % to 50% of the voltage of the power source. In this case, the control circuit may be configured to vary or modify the first control voltage that is supplied by the power source. Further, the amplitude of the signal supplied to the first switching element may oscillate between 0 V and the second control voltage in case the control circuit does not modify the switching signal. For example, the minimum voltage of the switching signal may be 0 V. Alternatively, the amplitude of the signal supplied to the first switching element may oscillate between a voltage greater than 0 V for supplying 5 % to 75 % of the voltage of the battery to the aerosol-generating unit and the second control voltage in case the control circuit does not modify the switching signal. In other words, the unchanged first voltage may be 0 V greater than 0 V (e.g. for supplying 5 % to 75 % of the voltage of the battery to the aerosol-generating unit) in some examples.

The lower AGU voltage level may be proportional to the first control voltage. Similarly, the higher AGU voltage level may be proportional to the second control voltage. Thus, for supplying 5 % to 75 % of the voltage of the power source to the to the aerosol-generating unit, the amplitude of the signal supplied to the first switching element may switch between 5 % to 75 % of the second control voltage.

However, other relationships between the lower AGU voltage level and the first control voltage as well as the higher AGU voltage level and the second control voltage are possible. In this case, the first control voltage may need to be modified to a higher or lesser degree for changing the lower AGU voltage level to be in the range of 5 % to 75 % of the voltage of the power source. For example, the first control voltage may be changed between 10% to 80% or between 20% to 50% of the second control voltage. This may depend on the characteristics of the first switching element.

The second control voltage may be higher than the first control voltage, optionally both in the changed and unchanged states. Similarly, the higher AGU voltage level may be higher than the lower AGU voltage level, optionally both in the changed and unchanged states. For example, the higher AGU voltage level may be higher than the lower AGU voltage level provided by the changed and/or unchanged first control voltages.

The unchanged or changed first control voltage may correspond to the minimum voltage level of the switching signal or the lower switching voltage level. The control circuit may be configured to increase the minimum voltage of the switching signal or the lower switching voltage level, for example from 0 V to 5 % to 75 % of the second control voltage (if the second control voltage sets the first switching element into the fully conducting state so that 100% of the voltage of the power source is supplied to the aerosol-generating unit). Further, the control circuit may be configured to increase the lower AGU voltage level, for example from 0 V to 5 % to 75 % of the voltage of the power source. Alternatively or additionally, the control circuit may be configured to decrease the minimum voltage of the switching signal or the lower switching voltage level, for example from 5 % to 75 % of the second control voltage to 0 V (if the second control voltage sets the first switching element into the fully conducting state so that 100% of the voltage of the power source is supplied to the aerosol-generating unit). Further, the control circuit may be configured to decrease the lower AGU voltage level, for example from 5 % to 75 % of the voltage of the power source to 0 V.

In some examples, one of the unchanged second control voltage or the changed second control voltage may be configured to control the first switching element to supply a higher AGU voltage level corresponding to a voltage of the power source to the aerosol-generating unit and the other one of the unchanged second control voltage and the changed second control voltage may be configured to control the first switching element to supply higher AGU voltage level in range of 40 % to 85 % of the voltage of the power source to the aerosol-generating unit.

In some examples, the higher AGU voltage level of the pulse-width modulation or the frequency modulation may be changed between a voltage of the power source and a voltage in the range of 40 % to 85 % of the voltage of the power source or vice versa.

Optionally, the higher AGU voltage level may be or may be modified to be in a range from 50 % to 85 % or 50 % to 75 % of the voltage of the power source. In this case, the control circuit may be configured to vary or modify the higher AGU voltage level that is supplied by the power source. Further, the amplitude of the control signal supplied to the first switching element may oscillate between the first voltage level and the maximum voltage of the switching signal in case the control circuit does not modify the switching signal. For example, the maximum voltage of the switching signal may be a voltage for fully opening the first switching element, i.e. the first switching element might not reduce the voltage supplied from the power source to the aerosol-generating unit. Alternatively, the amplitude of the control signal supplied to the first switching element may oscillate between the first voltage level and 40 % to 85 % of the voltage of the power source to the aerosol-generating unit in case the control circuit does not modify the switching signal.

The higher AGU voltage level may be proportional to the second control voltage. Thus, for providing 40 % to 85 % of the voltage of the power source to the to the aerosol-generating unit, the amplitude of the control signal supplied to the first switching element can switch between 40 % to 85 % of the maximum amplitude of the switching signal or a voltage for putting the first switching element in the fully conducting state in case the control circuit modifies the switching signal.

However, other relationships of the higher AGU voltage level and the second control voltage are possible. In this case, the second control voltage needs to be modified to a higher or lesser degree for changing the higher voltage to range of 40 % to 85 % of the voltage of the power source. For example, the second control voltage can be changed between 50% to 90% or between 50% to 70% of the maximum voltage of the switching signal or a voltage level for putting the first switching element in the fully conducting state.

The unchanged or changed second control voltage may correspond to the maximum voltage level of the switching signal (or the upper switching voltage level) or a voltage for setting the first switching element in the fully conducting state. The control circuit may be configured to reduce the maximal voltage of the switching signal or the upper switching voltage level, for example from 100% to 40 % to 85 % of the maximal voltage level of the switching signal or the upper switching voltage level. Further, the control circuit may only be configured to reduce the higher AGU voltage level, for example from 100 % to 40 % to 85 % of the voltage of the power source. Alternatively or additionally, the control circuit may be configured to increase the maximal voltage of the switching signal, for example from 40 % to 85 % to 100 % of the maximal voltage of the switching signal. Further, the control circuit may be configured to increase the higher AGU voltage level, for example from 40 % to 85 % to 100% of the voltage of the power source.

Optionally, the control circuit may be configured to concurrently switch the first control voltage and the second control voltage between the changed and unchanged states. For example, a switch of the first control voltage between the changed and unchanged states may occur at the same time as a switch of the second control voltage between the changed and unchanged states. A change in a modification signal (described further below) may prompt a change in both the first and second control voltages. The modification signal may be generated by the electrical circuitry for controlling a change between the changed and unchanged states of the first and second control voltages. The modification signal may prompt or trigger a modification of the control signal, e.g. by varying the switching signal. For example, a switch between a lower modification voltage level of the modification signal and an upper modification voltage level of the modification signal may prompt a change between the changed and unchanged states of the first and second control voltages

In some examples, the control circuit may be configured to switch the changed first control voltage to the unchanged first control voltage at the same time as the control circuit switches the unchanged second control voltage to the changed second control voltage (or vice versa). For example, in a first time window (corresponding to a lower modification voltage level of the modification signal), the first control voltage is 0 V and the second control voltage may be reduced compared to the maximum second control voltage for setting the first switching element in the fully conducting state. In a second time window after the first time window (e.g. upon switch a between the lower modification voltage level and the upper modification voltage level of the modification signal), the first control voltage may be increased and the second control voltage is increased to the maximum second control voltage. In this way, the baseline and/or the amplitude of the control signal can be changed, for example using the modification signal.

In some examples, the unchanged first control voltage may be configured to control the first switching element to supply the lower AGU voltage level of 0 V to the aerosol-generating unit, the unchanged second control voltage may be configured to control the first switching element to supply the higher AGU voltage level in range of 40 % to 85 % of the voltage of the power source to the aerosol-generating unit, the changed first control voltage is configured to control the first switching element to supply a lower AGU voltage level in range of 5 % to 75 % of the voltage of the power source to the aerosol-generating unit, and the changed second control voltage is configured to supply (substantially) the voltage of the power source to the aerosol-generating unit.

In this way, a shift of the lower AGU voltage level and the higher AGU voltage level can be generated by switching between the changed and unchanged first and second control voltages. For example, both the higher AGU voltage level and the lower AGU voltage level are modified when the modification signal prompts or triggers a modification of the control signal.

In some examples, a difference between the lower AGU voltage level provided by the unchanged first control voltage and the higher AGU voltage level provided by the unchanged second control voltage may be less than 40 %, 50 %, 60 %, 70 %, or 80% of difference between the voltage of the power source and 0 V and/or a difference between the lower AGU voltage level provided by the changed first control voltage and the higher AGU voltage level provided by the changed second control voltage may be less than 40 %, 50 %, 60 %, 70 %, or 80% of difference between the voltage of the power source and 0 V.

The difference between the lower AGU voltage level and the higher AGU voltage level may correspond to the amplitude of the voltage that is supplied to the aerosol-generating unit. In some examples, the amplitude between the lower AGU voltage level and the higher voltage may be less than 60 % of the voltage of the power source when the first and second control voltages are in the changed and unchanged states. In other words, the modification of the lower AGU voltage level and the higher AGU voltage level may affect both the lower AGU voltage level and the higher AGU voltage level in some examples. This may be implemented in that a change in the modification signal may affect both the first control voltage and the second control voltage.

In some examples, a first range between the lower AGU voltage level provided by the changed first control voltage and the higher AGU voltage level provided by the changed second control voltage does not overlap with a second range between the lower AGU voltage level provided by the unchanged first control voltage and the higher AGU voltage level provided by the unchanged second control voltage.

The first range may correspond to the amplitude between the lower AGU voltage level and the higher AGU voltage level when the first and second control voltages are in the changed state. The second range may correspond to the amplitude between the lower AGU voltage level and the higher AGU voltage level when the first and second control voltages are in the unchanged state. The control circuit may be configured to switch between the first range and the second range e.g. depending on a change in the modification signal. In some examples, the first range and the second range may not overlap. It is possible that the lower AGU voltage level in the changed state of the second control voltage may be equal to the higher AGU voltage level in the unchanged state of the first control voltage. Alternatively, there may be a gap between the lower AGU voltage level in the changed state of the second control voltage and the higher AGU voltage level in the unchanged state of the first control voltage.

In some examples, the electrical circuitry may be configured to maintain the unchanged higher AGU voltage level and/or the unchanged lower AGU voltage level supplied to the aerosol-generating unit over two or more cycles of the pulse-width-modulation and/or frequency modulation and/or less than 5, 10, 15, 20, 30, 50, or 100 cycles of the pulse-width-modulation and/or frequency modulation.

Optionally, the electrical circuitry may be configured to maintain the unchanged first control voltage and/or the unchanged second control voltage supplied to the first switching element over two or more cycles of the switching signal and/or less than 5, 10, 15, 20, 30, 50, or 100 cycles of switching signal.

In some examples, the electrical circuitry may be configured to maintain the changed higher level and/or the changed lower AGU voltage level supplied to the aerosol-generating unit over two or more cycles of the pulse-width-modulation and/or frequency modulation and/or less than 5, 10, 15, 20, 30, 50, or 100 cycles of the pulse-width-modulation and/or frequency modulation.

Optionally, the electrical circuitry may be configured to maintain the changed first control voltage and/or the changed second control voltage supplied to the first switching element over two or more cycles of the switching signal and/or less than 5, 10, 15, 20, 30, 50, or 100 cycles of switching signal.

The frequency of modification between the changed and unchanged first and second control voltages may be lower than the frequency of the switching signal. In this way, it is possible to supply the changed or unchanged higher AGU voltage level and/or lower AGU voltage level over two or more cycles of the switching signal. For example, the changed or unchanged higher AGU voltage level and/or lower AGU voltage level may be maintained over 2, 3, 4, 5, 6, 7, 8, 10, 15, or 20 cycles of the switching signal. Optionally, the number of cycles over which the changed or unchanged higher AGU voltage level and/or lower AGU voltage level is maintained may be predetermined or fixed. Alternatively, the electrical circuitry may be configured to adjust the number of cycles over which the changed or unchanged higher AGU voltage level and/or lower AGU voltage level is maintained, for example in view of the power to be supplied to the aerosol-generating unit.

In some examples, the unchanged higher AGU voltage level and the unchanged lower AGU voltage level may be supplied during a heat up phase of the aerosol-generating unit. This may be done because the unchanged higher AGU voltage level and the unchanged lower AGU voltage level may provide more power to the aerosol-generating unit than the changed higher AGU voltage level and/or lower AGU voltage level. For example, the unchanged higher AGU voltage level may correspond to the voltage of the power source and the unchanged lower AGU voltage level is 0 V. This may be helpful for quickly heating up the aerosol-generating unit. Once the aerosol-generating unit is heated up, the higher AGU voltage level may be changed/reduced for reducing the power supply to the aerosol-generating unit. The reduced power supply may be sufficient to maintain a constant temperature with the aerosol-generating unit. The lower AGU voltage level may remain unchanged, e.g. at 0 V.

Alternatively, the changed lower AGU voltage level may be supplied during a heat up phase of the aerosol-generating unit, for example the changed lower AGU voltage level may be 5 % to 75 % of a voltage of the power source and the higher AGU voltage level is the voltage of the power source. This may be done because the changed lower AGU voltage level may provide higher power to the aerosol-generating unit than the unchanged lower AGU voltage level. This may be helpful for quickly heating up the aerosol-generating unit. Once the aerosol-generating unit is heated up, the lower AGU voltage level may be changed/reduced for reducing the power supply to the aerosol-generating unit. The reduced power supply may be sufficient to maintain a constant temperature with the aerosol-generating unit. For example, the unchanged lower AGU voltage level may be 0 V. Thus, the unchanged lower and higher AGU voltage levels may correspond to a switch between 0 V and the voltage of the power source and the changed lower and higher AGU voltage levels may correspond to a switch between 5 % to 75 % of a voltage of the power source and the voltage of the power source.

Of course, the above-described examples may be applied to other time frames. For example, the above-described examples may be used to modifying the power supply to the aerosol-generating unit. In some cases, there is a switch from the unchanged to changed upper and/or lower AGU voltage levels for modifying the power supply while the switching signal is not changed (e.g. the PWM signal or the FM signal is not changed such as no change in the duty cycle or frequency).

The first control voltage may correspond to a lower limit of a control signal supplied to the first switching element and/or the second control voltage may correspond to an upper limit of a control signal supplied to the first switching element. Thus, the control signal may oscillate between the first control voltage and the second control voltage. If the control signal includes square wave or a plurality of pulses, the first control voltage may correspond to a base line and the second control voltage may correspond to the maximal amplitude of the control signal.

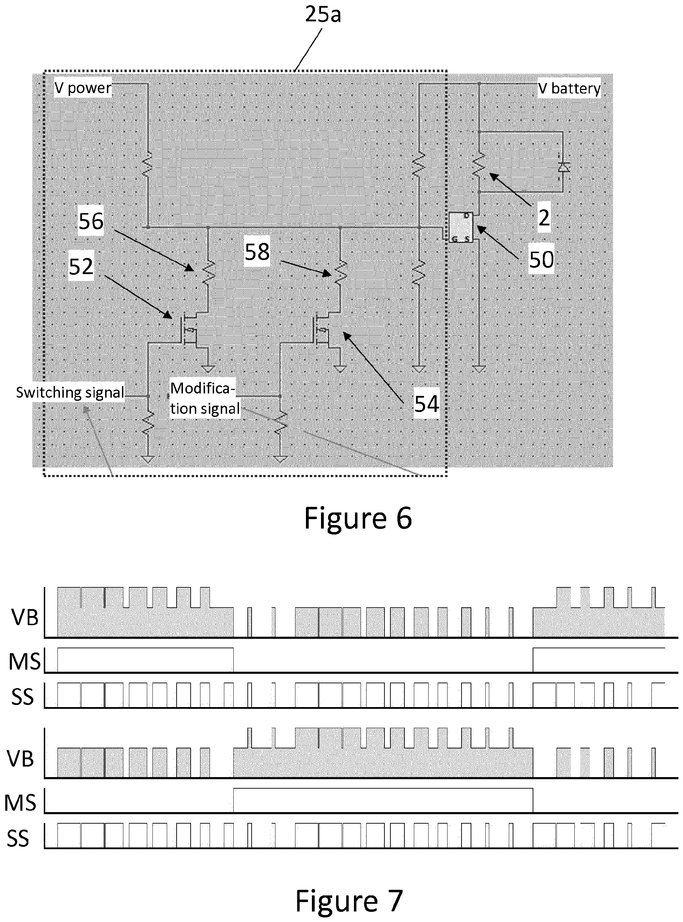

In some examples, the electrical circuitry may include a controller. The controller may be for generating (e.g. configured to generate) the switching signal of the pulse-width-modulation and/or frequency modulation. The controller may also be for generating (e.g. configured to generate) a modification signal which may be used for changing the first control voltage and/or the second control voltage. For example the modification signal switches between the upper modification voltage level and the lower modification voltage level. The switching of the modification signal (between its upper modification voltage level and lower modification voltage level) may be controlled separately from the switching of the switching signal (between its upper switching voltage level and lower switching voltage level). For example, the switching of the modification signal may occur less frequently than the switching of the switching signal (see e.g. Figures 7-9 discussed below).

The electrical circuitry may further include a second switching element and/or a third switching element connected in parallel with the second switching element. Optionally, the switching signal and the modification signal are used with the second switching element and the third switching element to generate the control voltage.

The processing resource described above may be an example of the controller. The switching signal of the pulse-width-modulation and/or frequency modulation may switch between the upper switching voltage level and the lower switching voltage level, and may be generated as known in the prior art.

The second switching element and/or the third switching element may have the same optional features, characteristics, and/or embodiments as the first switching element. The switching signal may be supplied to the second switching element and/or the third switching element, for example to gate of the second switching element and/or the third switching element, for controlling a conducting state of the second switching element and/or the third switching element, respectively. The source of the second switching element and/or the third switching element may be connected to the ground. The drain of second switching element and/or the third switching element may be connected to a voltage source, e.g. directly the power source or indirectly to the power source such as via a voltage reduction circuit for reducing the voltage of the power source, such as one or more resistors. Further, it is possible that the electrical circuitry is configured to supply a constant voltage to the drain of the second switching element and/or the third switching element.

The source or drain of the second switching element and/or the third switching element may further be connected to the first switching element, e.g. the gate of the first switching element. In this way, the opening or closing of the second switching element and/or the third switching element may affect the first control voltage and/or the second control voltage. Further, it is possible that the signals supplied to the gate of second switching element and/or the third switching element may switch between 0 V and a voltage for fully opening the first second switching element and/or the third switching element.

The control circuit may further include one or more resistors, capacitors, and/or inductors that can be connected to the second switching element and/or the third switching element. The second switching element may form a first voltage divider and/or the third switching element may form second voltage divider. The first and/or second power divider may selectively reduce the voltage supplied to the first switching element.

Optionally, the controller may be configured to supply the modification signal to the second switching element and/or the third switching element. The modification signal may be a signal that determines whether the first control voltage and/or the second control voltage is in the changed or unchanged state. For example, the modification signal may encode its information in a voltage supplied to the second switching element and/or the third switching element. In some examples, the modification signal may switch between the lower modification voltage level and the upper modification voltage level, wherein the second or third switching element is the non-conducting state if the lower modification voltage level is supplied and the second or third switching element is the conducting state if the upper modification voltage level is supplied. Of course, the voltage of the modification signal may be between the lower modification voltage level and the upper modification voltage level for setting the second or third switching element between the fully conducting state and the fully non-conducting state. The frequency of the modification signal may be less than the frequency of the switching signal such that the first and/or second control voltages remain in the changed or unchanged state over two or more cycles of the switching signal. The modification signal may include a square wave or a plurality of pulses. For example, each pulse may correspond to modifying the first and/or second control voltages to the changed state.

For example, the switching signal may encode its information in a voltage supplied to the second switching element and/or the third switching element. In some examples, the switching signal may switch between the lower switching voltage level and the upper switching voltage level, wherein the second or third switching element is the non-conducting state if the lower switching voltage level is supplied and the second or third switching element is the conducting state if the upper switching voltage level is supplied.

In some examples, the control circuit may be configured to selectively supply the switching signal of the pulse-width-modulation and/or frequency modulation to the second switching element and to open and close to the second switching element for switching between a first pair of the changed and unchanged first or the second control voltage.

Opening and closing the second switching element may be controlled by the modification signal.

The second switching element (e.g. a gate of the second switching element) may be (selectively) connected to the controller for receiving the switching signal. As the second switching element is connected to the first switching element, the switching signal may be forwarded to the first switching element. In particular, the time behaviour of the switching signal may be forwarded to the second switching element without any changes. In other in this way, the PWM signal or the FM signal can be supplied to the first switching element without changing its time.

The switching signal supplied to the second switching element may have a constant amplitude, e.g. may oscillate between a lower level and upper level. The amplitude of the switching signal may be modified by the third switching element. If the third switching element is in an open state, the first control voltage and/or the second control voltage may be in the unchanged state. Closing the third switching element may put the first control voltage and/or the second control voltage in the changed state. The first control voltage and/or the second control voltage may be different to the upper switching voltage level and/or the lower switching voltage level, respectively, of the switching signal. In other words, the control circuit may modify the upper switching voltage level and/or the lower switching voltage level of the switching signal in both the conducting state and the non-conducting state of the third switching element. However, the degree of modification may depend on the conducting state of the third switching element.

For example, the switching signal may oscillate between 0 V and the upper switching voltage level. Due to the arrangement of the third switching element, this may result in an unchanged first control voltage and second control voltage which may oscillate between a maximum second control voltage and a first control voltage that is higher than 0 V (e.g. 50% of the maximum second control voltage). Closing the third switching element may change the first control voltage to 0 V and the second control voltage to a value smaller than the maximum second control voltage (e.g. to 50 %). The amount of the unchanged first and/or second control voltages and the amount of the changed first and/or second control voltages may depend on the arrangement of the second and third switching elements and the other components provided with the control circuit. Further, the respective electrical connections to the first switching element may also determine the change of the switching signal depending on the open or closed state of the third switching element. In this way, the configurations of the control circuit can be used to selectively set the first and/or second control voltages in the changed state and/or the unchanged state.

In some examples, the control circuit may be configured to selectively supply the switching signal of the pulse-width-modulation and/or frequency modulation to the third switching element and to open and close the third second element for switching between a second pair of the changed and unchanged first or the second control voltage.

Opening and closing the third switching element may be controlled by the modification signal.

Such examples may be used with the same configuration of the control circuit as described above. However, in such examples, the switching signal may be supplied to the third switching element, rather than the second switching element as described above. Similarly, the state of the second switching element may be used to switch between the changed and unchanged first and second control voltages. This may result in a different pair of changed and unchanged first and second control voltages as the second and third switching elements are connected in different manner to the first switching element.

Thus, by selectively routing the switching signal to either the second switching element or the third switching element and opening or closing the respective other of the second and third switching elements, two pairs of unchanged and changed first and second control voltages can be generated. In this way, by using the same configuration of the control circuit, two different first control voltages and/or two different second control watches can be generated.

In some examples, the control circuit is configured to selectively supply the switching signal of the pulse-width-modulation and/or frequency modulation simultaneously to the second and third switching elements for switching the voltage supplied to the aerosol-generating unit between the voltage of the power source and zero voltage.

The switching signal may simultaneously or concurrently be supplied to both the first and the second switching element. Such examples may be used to supply the switching signal to the first switching element without changing the amplitude of the switching signal. In this case, the first control voltage may correspond to the lower switching voltage level of the switching signal and the second control voltage may corresponds to the upper switching voltage level of the switching signal.

This example may be used with the same configuration as previously described. In this way, 3 different levels of the first control voltage and/or three different levels of the second control voltage can be generated by the selectively supplying the switching signal to second switching element, the third switching element, or both the second and the third switching elements.

In some examples, the control circuit may include a first resistor connected in series with the second switching element and a second resistor connected in series with the third switching element.

A resistance of the first resistor and the resistance of the second resistor may determine the value of the first control voltage and the second control voltage if the switching signal is supplied to either the second switching or the third switching element - similar to the examples outlined above. Thus, by setting the values of the resistances of the first resistor and the second resistor, the different levels of first control voltage and the second control voltage can be set.

The first resistor and the second resistor may have fixed or non-tuneable resistances.

In some examples, the first resistor and/or the second resistor are tuneable, optionally for modifying the resistances of the first resistor and/or the second resistor.

The resistance of the first resistor and/or the second resistor may be controlled by a user of the aerosol-generating system. For example, the level of the resistance of the first resistor and/or the second resistor may be controlled by using an input device of the aerosol generating system and/or using the external device communicating with the and/or the wireless interface of the aerosol generating system. For example, changing the level of resistance of the first resistor and/or the second resistor may be used for controlling the amount of power supplied to the aerosol-generating unit, such as for setting the amount of aerosol that is generated by the aerosol-generating unit.

It is possible that the level of resistance of the first resistor and/or the second resistor may be changed between two or more levels which may correspond to two or more levels of aerosol, respectively, that is generated by the aerosol-generating unit. The input device and/or the wireless interface may be in data communication with the first resistor and/or the second resistor for changing their respective resistances.

In some examples, the controller may be configured to tune the first resistor and/or the second resistor for changing levels of the first control voltage and/or the second control voltage.

The resistance of the first resistor and/or the second resistor may be controlled by the controller. For example, the controller is in data communication with the first resistor and the second resistor to control the respective resistances. In this way, by tuning the values of the resistances of the first resistor and/or the second resistor, the different levels of first control voltage and/or the second control voltage can be modified.

The controller may automatically change the levels of resistance of the first resistor and/or the second resistor for controlling the amount of power supplied to the aerosol-generating unit. In this way, the electrical circuitry may be configured to vary or modify the supply of power to the aerosol-generating unit not only by modifying the switching signal but also by changing the amplitude of the first control voltage and/or the second control voltage. This may result in a fine or precise control of the power supplied to the aerosol-generating unit and, therefore, the amount of aerosol that is generated.

The preceding summary is provided for purposes of summarizing some examples to provide a basic understanding of aspects of the subject matter described herein. Accordingly, the above-described features should not be construed to narrow the scope of the subject matter described herein in any way. Moreover, the above and/or following examples may be combined in any suitable combination to provide further examples, except where such a combination is clearly impermissible or expressly avoided. Other features, aspects, and advantages of the subject matter described herein will become apparent from the following text and the accompanying figures.

### BRIEF DESCRIPTION OF THE FIGURES

Aspects, features and advantages of the present disclosure will become apparent from the following description of examples in reference to the appended figures in which like numerals denote like elements.
**Figure 1** shows an example of an aerosol-generating system;
**Figure 2** shows internal components of the aerosol-generating system of Figure 1;
**Figure 3** shows a further example of the aerosol-generating system;
**Figure 4** shows the components of the aerosol-generating system of Figure 3 in a 'disengaged state';
**Figure 5** shows the components of the aerosol-generating system of Figure 3 in an 'engaged state';
**Figure 6** shows a circuit diagram of a control circuit for controlling a first switching element used with the aerosol-generating system of Figure 1 or Figure 3;
**Figure 7** shows the exemplary temporal behaviour of the voltage supplied to an aerosol-generating unit (indicated as "VB") resulting from a switching signal (indicated as "SS") and a modification signal (indicated as "MS") for a first supply configuration (as depicted in Figure 6);
**Figure 8** shows the exemplary temporal behaviour of the voltage supplied to an aerosol-generating unit (indicated as "VB") resulting from a switching signal (indicated as "SS") and a modification signal (indicated as "MS") for a second supply configuration;
**Figure 9** shows the exemplary temporal behaviour of the voltage supplied to an aerosol-generating unit (indicated as "VB") resulting from a switching signal (indicated as "SS") for a third supply configuration;
**Figure 10** shows exemplary curves of voltages modelled for the control circuit of Figure 6, wherein the first (upper) row and the third row show the same pulse-frequency modulation without voltage modulation (first row) and with voltage modulation (third row), and wherein second row and the fourth (lower) row show another example of the same pulse-frequency modulation without voltage modulation (second row) and with voltage modulation (fourth row); and
**Figure 11** shows a block diagram of exemplary steps of a method for controlling the aerosol-generating unit of the aerosol-generating system of Figure 1 or Figure 3.

### DETAILED DESCRIPTION OF EMBODIMENTS

It is to be understood that the present disclosure, which includes the specification and claim(s), is not limited by specific construction details or method steps. Rather, it will be clear to those skilled in the art that the systems, apparatuses, and methods described herein can be embodied and practiced in various alternative ways without departing from the scope of the invention.

Unless defined otherwise, scientific and technical terms used herein have their meanings commonly understood by those skilled in the art and that known techniques and procedures may be performed according to conventional methods.

In the present disclosure, the terms "a" and "an" may mean "one", "one or more", "at least one", and "one or more than one" unless the context clearly indicates otherwise. Likewise, plural terms shall include the singular unless otherwise required by context.

In the present disclosure, the term "or" means an inclusive "and/or" unless explicitly indicated to refer to alternatives only or unless the alternatives are mutually exclusive.

In the present disclosure, the terms "comprising, "having," "including," or "containing" (and any forms thereof, such as "comprise" and "comprises," "have" and "has," "includes" and "include," or "contains" and "contain," respectively) are inclusive or open-ended and do not exclude additional, unrecited elements or method steps.

Unless stated otherwise, the features of examples disclosed herein, and of the claims, may be integrated together in any suitable arrangement such that combinations of features are not limited by the described forms, particularly the form (e.g. numbering) of example(s), embodiment(s), or dependency of claim(s). This also applies to the phrase "in one example", "according to an example" and the like, which are merely a stylistic form of wording not to be construed as limiting the features to a separate embodiment. This is to say, a reference to 'an,' 'one,' or 'some' examples(s) may be a reference to any one or more, and/or all examples, or combination(s) thereof, disclosed. Also, similarly, reference to "the" example may not be limited to the immediately preceding embodiment. Further, all references to one or more embodiments or examples are to be construed as non-limiting to the claims.

The present disclosure may be better understood in view of the following explanations, wherein the terms used that are separated by "or" may be used interchangeably.

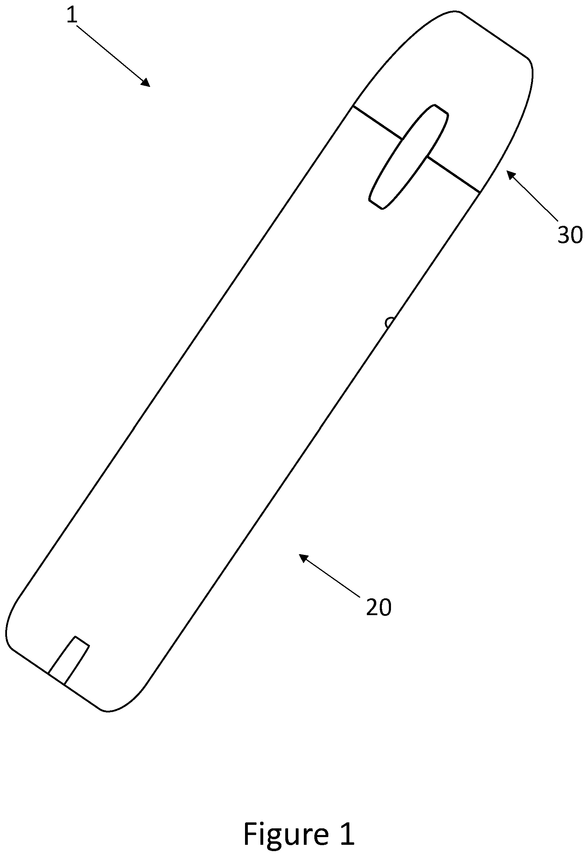

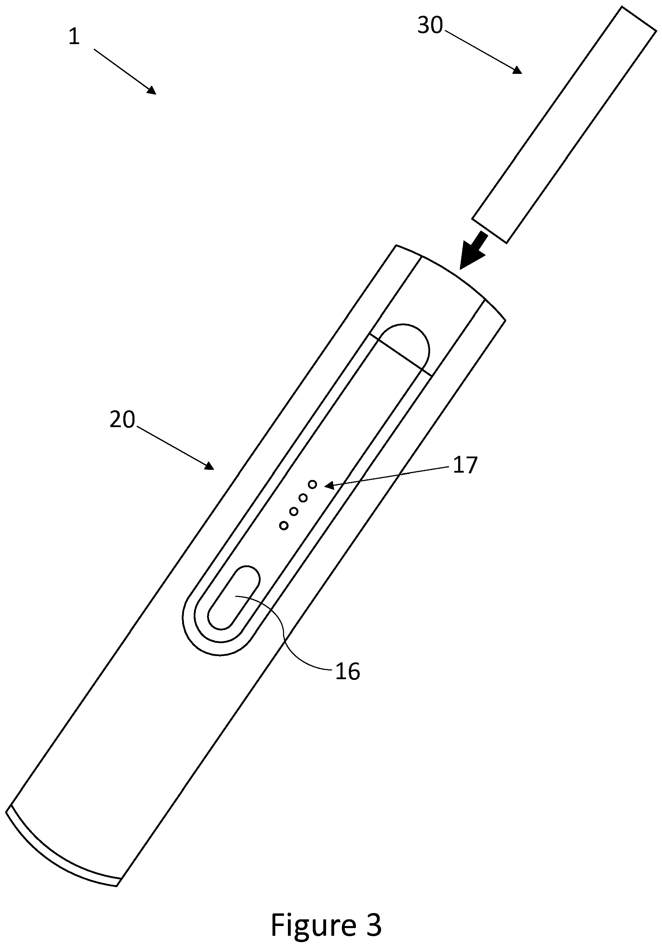

Figure 1 shows an example of an aerosol-generating system 1. In this example, the aerosol-generating system 1 is an electronic vapour product (EVP) configured to produce an aerosol from an aerosol-forming material 10 (e.g. a liquid or gel precursor), although it will be appreciated that the aerosol-generating system 1 may be similarly applicable to a heat-not-burn product (HNB) configured to produce an aerosol from heating an aerosol-forming material (e.g. a solid precursor such as tobacco) to a temperature below its combustion temperature (see Figures 3 to 5).

The term "aerosol-forming material" refers to a substrate or formulation capable of releasing volatile components that can form an aerosol, e.g. by releasing volatile compounds in the aerosol-forming material. An "aerosol" is a dispersion of solid particles and/or liquid droplets dispersed in a gas. The aerosol may be visible or invisible.

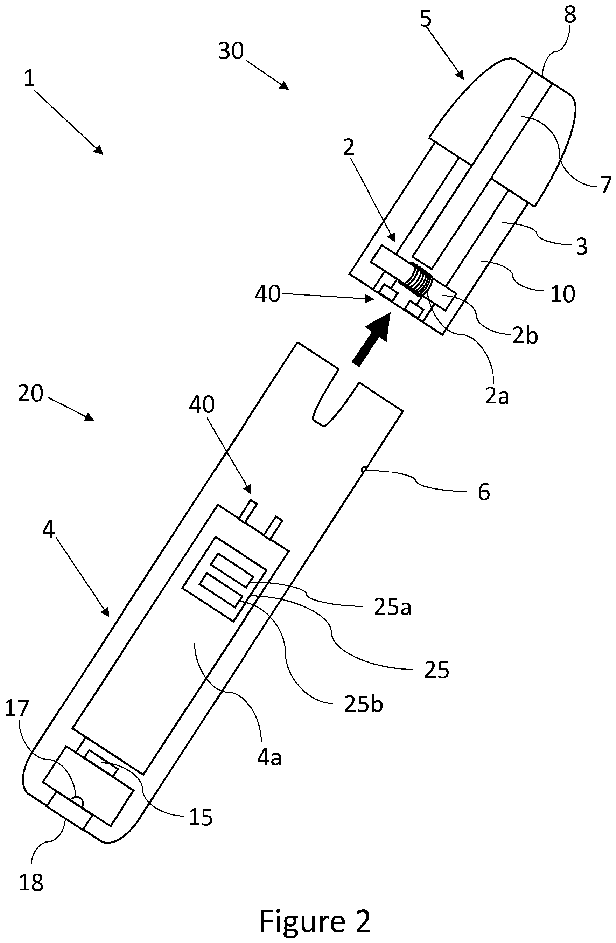

Figure 2 shows a schematic representation of the internal components of the aerosol-generating system 1. The aerosol-generating system 1 comprises an aerosol-generating unit 2 configured to generate an aerosol from an aerosol-forming material 10 held in a storage portion 3 of the aerosol-generating system 1 (implemented here as a "tank"). In this example, the aerosol-generating unit 2 is a heating system including a heating element 2a although it will be appreciated that an aerosol-generating unit comprising an ultrasonic element, atomiser or similar component may be provided.

The aerosol-forming material 10 may be referred to as "e-liquid". Typically, the aerosol-forming material 10 includes a base liquid and optionally nicotine and/or flavourings such that the resulting aerosol contains nicotine and/or flavourings.

The aerosol-generating system 1 includes a power source 4. In this example, the power source 4 includes a battery 4a configured to supply electrical energy to operate the aerosol-generating unit 2 and other components. The aerosol-generating system 1 may be powered, alternatively or in addition to the battery 4a, by an external power source. In an alternative example, the power source 4 may be omitted, e.g. an aerosol aerosol-generating unit implemented as an atomiser with flow expansion may not require a power supply.

The aerosol-generating system 1 includes an aerosol-delivery system 5 for delivery of the aerosol to a user. In this example, the aerosol-delivery system 5 comprises an air inlet 6, a mouthpiece 8, and an air passageway 7 extending therebetween via a region in proximity to the aerosol-generating unit 2.

The aerosol-generating unit 2 includes a wick 2b having at least one end that extends into the storage portion 3 and is configured to draw aerosol-forming material 10 out from the storage portion 3. In this example, the heating element 2a is in the form of a heating filament wrapped around a portion of the wick 2b. In this manner, the heating element 2a can heat up the aerosol-forming material 10 drawn out of the storage portion 3 by the wick 2b to produce the aerosol, which is then drawn through the air passageway 7 to the mouthpiece 8. In other examples, the heating element 2a may be a mesh heater, ceramic heater, or other means of generating heat. The heating element 2a may be part of an induction heater having a susceptor configured to produce heat when penetrated by an alternating magnetic field.

The aerosol-generating system 1 may be a two-part construction comprising a device body 20 and an article 30 (alternatively referred to as a "pod" or "cartomizer") configured to be releasably connected/disconnected by an end user. The device body 20 and article 30 are each configured to house respective components of the aerosol-generating system 1.

In some examples, the article 30 may be configured to be disposed of upon depletion of aerosol-forming material 10 from the storage portion, in which case the article 30 may referred to as a "consumable". Alternatively, the article 30 may be configured for reuse, such that it is configured to be refillable upon depletion of the aerosol-forming material 10 from the storage portion.

In this example, the device body 20 comprises the power source 4, and the article 30 comprises the aerosol-generating unit 2 and storage portion 3, although it will be appreciated that the device body 20 and article 30 may house any respective set of components. The device body 20 and article 30 are configured to physically interlock to secure the article 30 relative to the device body 20.

Upon connection, electrical connectors 40 of the device body 20 and article 30 may establish an electrical connection between the device body 20 and the article 30. In this way, electrical power can be supplied from the power source 4 to the aerosol-generating unit 2 (or other components of the article 30) without the article 30 needing to have its own power supply.

The device body 20 may include any one or more of electrical circuitry 25, a memory, a wireless interface, and one or more other components. The electrical circuitry 25 includes a control circuit 25a and a controller 25b. The device body 20 may include a printed circuit board (PCB) on which components of the electrical circuitry 25, such as the control circuit 25a and the controller 25b, the memory, wireless interface, and other components may be mounted.

The electrical circuitry 25 may include one or more processing resources for controlling one or more operations of the body 20 and article 30, e.g. based on instructions stored in the memory. The wireless interface may be configured to communicate wirelessly with an external (e.g. mobile) device, e.g. via Bluetooth. The other component(s) may include one or more user interface devices configured to convey information to a user, a pressure sensor 15, and/or a charging port 18 (see e.g. figure 2).

The aerosol-generating system 1 may comprise one or more input and/or output elements. In this example, the aerosol-generating system 1 includes an input element in the form of a pressure sensor 15 arranged to detect a "puff" of the user, and particularly the resultant change in air pressure, i.e. a vacuum pressure generated by the user. Alternatively, or in addition, the aerosol-generating system 1 may include other means of detecting airflow, such as a flowmeter or microphone. The user can thereby activate the aerosol-generating unit 2 when inhaling through the mouthpiece 8. The aerosol-generating unit 2 creates an aerosol which is carried by the flow through the air passageway 7 and out of the mouthpiece 8.

The input and/or output elements may form part of a user interface (UI) of the aerosol-generating system 1. For instance, Figure 2 shows an output element in the form of a light (e.g. an LED) 17. The light 17 is configured to convey information to the user regarding the state of the system 1. It will be appreciated that the input element(s) may be provided in various forms, such as touch screens, switches, and sensors, and the output element(s) may be provided in various forms, such as display screens, speakers, or a haptic output generated by a vibration generator.

Figure 3 shows an example of an aerosol-generating system 1 comprising a device body 20 and an article 30 (alternatively referred to as a "consumable") for insertion into the device body 20. In this example, the device body 20 is a heat-not-burn device (HNB) configured to produce an aerosol by heating an aerosol-forming material 10 (e.g. a solid precursor, such as tobacco material) to a temperature below its combustion temperature, although it will be appreciated that the invention may be similarly applicable to an electronic vapour product (EVP) configured to produce an aerosol from an aerosol-forming material (e.g. a liquid or gel precursor).

The term "aerosol-forming material" refers to a material capable of releasing volatile components that can form an aerosol, e.g. by releasing volatile compounds in the aerosol-forming material 10. An "aerosol" is a dispersion of solid particles and/or liquid droplets dispersed in a gas. The aerosol may be visible or invisible.

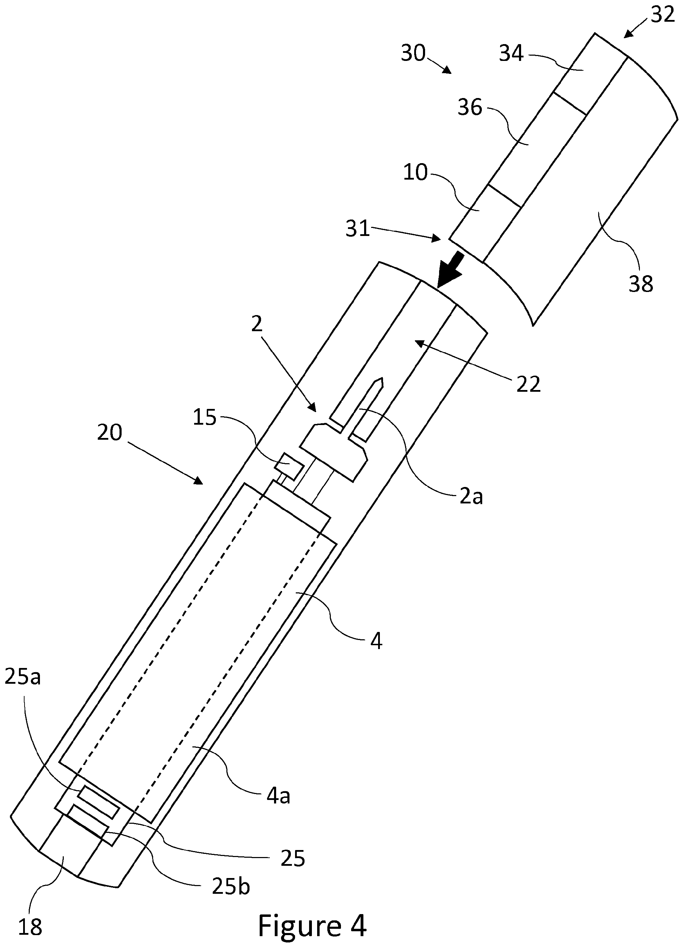

Figure 4 shows a schematic representation of the internal components of the device body 20 and article 30. The device body 20 and article 30 are shown in a "disengaged state" in which the article 30 is separated from the device body 20.

The aerosol-generating system 1 has an aerosol-generating unit 2 in the form of a heating system. The heating system comprises a heating element 2a configured to penetrate the article 30. The heating element 2a heats the aerosol-forming material 10 to a temperature lower than its combustion temperature such that an aerosol can be formed by evaporation, torrefaction and pyrolysis.

The aerosol-generating system 1 includes the power source 4. In this example, the power source 4 includes a battery 4a configured to supply electrical energy to operate the aerosol-generating unit 2 and other components. The aerosol-generating system 1 may be powered, alternatively or in addition to the battery 4a, by an external power source.

The article 30 defines an air passageway which transmits aerosol generated from the aerosol-forming material 10 to a downstream end 32 (i.e. terminal end or mouth end) of the article 30. The article 30 may comprise one or more filter elements 34, one or more spacer elements 36, and one or more wrapping layers 38 (e.g. paper, foil or composite layers). One or more of the filter elements 34 and spacer elements 36 may define the air passageway. In the present example, the article 30 comprises an aerosol-forming material 10 at the upstream end 31 of the article 30, a filter element 34 at the downstream end 32, and a spacer element 36 positioned between them, all circumscribed by a wrapping layer 38.

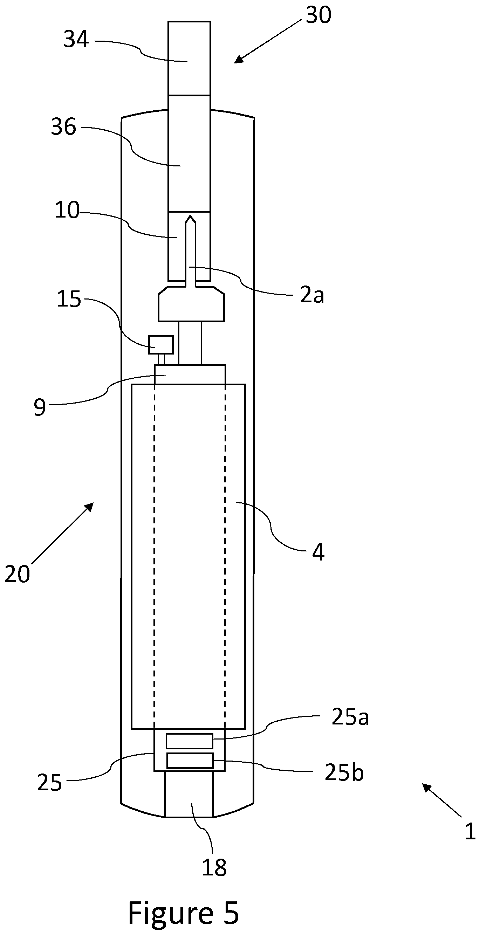

Figure 5 shows the aerosol-generating system 1 in an "engaged state" in which the article 30 is inserted into an internal chamber 22 of the device body 20.

In this example, the heating element 2a is configured to penetrate the article 30. The heating element 2a is arranged to extend along a length of the aerosol-forming material 10 when inserted therein, such that when the heating element 2a is activated, heat is transferred radially outward from the heating element 2a to the aerosol-forming material 10 resulting in formation of an aerosol. This may be referred to as an 'inside-out' heating arrangement. The aerosol is subsequently entrained in an airflow produced by the action of the user drawing on the downstream end 32 of the article 30.

In alternative examples, the heating element 2a may be configured to at least partially encircle the article 30, such that when the heating element 2a is activated, heat is transferred radially inward from the heating element 2a to the aerosol-forming material 10. This may be referred to as an 'outside-in' heating arrangement.

In this example, the heating element 2a is a resistive heating element although it will be appreciated that the aerosol-forming material 10 may be heated by any suitable means. For instance, the heating element 2a may comprise a susceptor (not shown) configured to produce heat when penetrated by an alternating magnetic field.

The device body 20 may include any one or more of electrical circuitry 25, a memory, a wireless interface, and one or more other components. The electrical circuitry 25 includes a control circuit 25a and a controller 25b. The device body 20 may include a printed circuit board (PCB) on which components of the electrical circuitry 25, memory, wireless interface, and other components may be mounted.

The electrical circuitry 25 may include a processing resource for controlling one or more operations of the body 20 and article 30, e.g. based on instructions stored in the memory. The controller 25b is an example of the processing resource. The wireless interface may be configured to communicate wirelessly with an external (e.g. mobile) device, e.g. via Bluetooth. The other component(s) may include one or more user interface devices configured to convey information to a user, a pressure sensor 15, and/or a charging port 18.

The aerosol-generating system 1 may comprise one or more input and/or output elements. The input and/or output elements may form part of a user interface (UI) of the system 1. For instance, figure 1 shows an input element in the form of a button 16 and an output element in the form of a set of lights (LEDs) 17. The button 16 is configured to control at least one function of system 1, such as power supply to the heating element 2a. The lights 17 are configured to convey information to the user regarding the state of the system 1 and/or article. It will be appreciated that the input element(s) may be provided in various forms such as touch screens, switches, and sensors, and the output element(s) may be provided in various forms such as display screens, speakers, or a haptic output generated by a vibration generator.

Figure 6 shows a circuit diagram of some of the electrical circuitry 25 which includes a first switching element 50 and the control circuit 25a (the controller 25b, which is also part of the electrical circuitry is not shown in Figure 6). The first switching element 50 is connected in series with the aerosol-generating unit 2. In particular, the aerosol-generating unit 2 is connected between a terminal of the power source 4 (indicated in Figure 6 as "V battery") and the first switching element 50. If the first switching element 50 is in an open or non-conducting state, no current can flow through the aerosol-generating unit 2. This is an example of a lower AGU voltage level. If the first switching element 50 is in a closed or conducting state, a current can flow from the power source 4 to a ground. This is an example of an higher AGU voltage level. In this way, the first switching element 50 can be used to control the voltage and, optionally the power, that is supplied to the aerosol-generating unit 2.

In this example, the control circuit 25a includes a second switching element 52, a third switching element 54, a first resistor 56, and a second resistor 58. The first switching element 50, the second switching element 52, and/or the third switching element 54 may each include a FET, such as a junction FET (JFET) and metal-oxide-semiconductor FET (MOSFET). A gate of the first switching element 50 may be connected to the control circuit 25a. In other words, the control circuit 25a may control the voltage today supplied to the gate of the first switching element 50.

The control circuit 25a may be connected to the power source 4 or receives power from the electrical circuitry 25. For example, the voltage (indicated as "V power" in Figure 6) supplied to the control circuit 25a may be fixed (e.g. does not depend on the voltage of the power source 4) and/or may be smaller than the voltage of the power source 4.

The first resistor 56 and the second switching element 52 may be connected in series between a terminal for power supply (indicated as "V power" in Figure 6) and a ground. Similarly, the second resistor 58 and the third switching element 54 may be connected in series between the terminal for power supply (indicated as "V power" in Figure 6) and the ground. The second switching element 52 and the third switching element 54 may be connected in parallel. The assembly of the second switching element 52, the third switching element 54, the first resistor 56, and/or the second resistor 58 may form two voltage dividers for varying or modifying the voltage that is supplied to the first switching element 50.

The controller 25b (which is not shown in Figure 6, but which also forms part of the electrical circuitry 25) is configured to generate a switching signal and a modification signal. The switching signal may be a signal for implementing pulse-width modulation or frequency modulation.

In the example depicted in Figure 6, which is referred to herein as a "first supply configuration", the controller 25b is configured to supply the switching signal to the gate of the second switching element 52 and is configured to supply the modification signal to the gate of the third switching element 54.

In another example (not depicted in Figure 6), which is referred to herein as a "second supply configuration", the controller 25b is configured to supply the modification signal to the gate of the second switching element 52 and is configured to supply the switching signal to the gate of the third switching element 54.

In another example (not depicted in Figure 6), which is referred to herein as a "third supply configuration", the controller 25b is configured to supply the switching signal to both the gate of the second switching element 52 and the gate of the third switching element 54 (in this configuration, the modification signal is not supplied to either the second or third switching elements 52, 54).

Figure 7 shows the exemplary temporal behaviour of the voltage supplied to the aerosol-generating unit 2 (indicated as "VB") resulting from a switching signal (indicated as "SS") and a modification signal (indicated as "MS") for the first supply configuration depicted in Figure 6.

As can be seen from Figure 7, the switching signal includes an upper switching voltage level and a lower switching voltage level. The modification signal each include an upper modification voltage level and a lower switching voltage level. The lower switching voltage level and/or the lower modification voltage level may e.g. be 0 V. If the switching signal supplies the lower switching voltage level to the gate of the second switching element 52, the second switching element 52 may be in the closed or non-conducting state. If the switching signal supplies the upper switching voltage level to the gate of the second switching element 52, the second switching element 52 may be in the fully open or fully conducting state. If the modification signal supplies the lower modification voltage level to the gate of the third switching element 54, the third switching element 54 may be in the closed or non-conducting state. If the modification signal supplies the upper modification voltage level to the gate of the third switching element 54, the third switching element 54 may be in the fully open or fully conducting state.

The control circuit 25a controls the first switching element 50 by generating a control signal which may correspond to a selective combination of the switching signal and the modification signal. For example, the control signal may be a (modified) product of the switching signal and the modification signal. The control signal may switch between a first control voltage and a second control voltage. If the control circuit 25a supplies the first control voltage to the gate of the first switching element 50, the lower AGU voltage level is supplied to the aerosol-generating unit 2. If the control circuit 25a supplies the second control voltage to the gate of the first switching element 50, the higher AGU voltage level is supplied to the aerosol-generating unit 2. The diagram of Figure 7 showing the voltage supplied to the aerosol-generating unit 2 may be proportional to the control signal. In other words, the control signal may have the same temporal behaviour as shown in the diagram of Figure 7 showing the voltage supplied to the aerosol-generating unit 2.

The operation of the control circuit 25a for the first supply configuration depicted in Figure 6 will be described in the following with reference to Figure 7.

A PWM drive signal (an example of the switching signal) is generated by the controller 25b and is supplied to the gate of the second switching element 52 which is connected to the first switching element 50 forming a potential divider in combination with the first resistor 56. This PWM signal switches the second switching element 52 between conducting and non-conducting states so as to connect/disconnect the potential divider to ground. The effect of the switching signal is to produce a square-wave voltage at the gate of the first switching element 50. The square-wave voltage defines when the first control voltage and the second control voltage is supplied.

A drain of the first switching element 50 is connected to the power source 4 "V battery" via the aerosol-generating unit 2 so that the pulsed opening/closing of the gate of the first switching element 50 allows a current to flow from the power source 4, through the aerosol-generating unit 2 and to ground (via the first switching element 50).

The third switching element 54 is positioned in series with the second resistor 58 for forming a further potential divider. The modification signal switches between the lower modification voltage level (e.g. 0 V) and the upper modification voltage level so as put the third switching element 54 in the non-conducting state and the conducting state, respectively. This connects/disconnects the further potential divider to ground. This has the effect of changing the amplitude of the voltage delivered to the gate of the first switching element 50. The upper rows of the diagrams of Figure 7 shows the temporal behaviour of an exemplary voltages VB supplied to the aerosol-generating unit 2. The voltage VB may be proportional to the control signal and illustrates the effect of turning the modification signal on and off. Further, the upper rows of the diagrams of Figure 7 also indicate the temporal change of the first control voltage and the second control voltage, i.e. the temporal change of the control voltage that is generated by the control circuit 25a. It is apparent from Figure 7 how the modification signal modifies between which levels of the first control voltage and the second control voltage the control signal oscillates.

Similarly, the upper rows of the diagrams of Figure 7 show the effect on the potential/voltage signal delivered by the drain of the first switching element 50 to the connected end of the aerosol-generating unit 2, leading to the potential difference (voltage) across the aerosol-generating unit 2 depicted in the upper rows of the diagrams of Figure 7. Further, the upper rows of the diagrams of Figure 7 show the temporal change of the higher AGU voltage level and the lower AGU voltage level. As apparent from Figure 7, the lower AGU voltage level and the higher AGU voltage level as well as the first control voltage and the second control voltage are maintained over several cycles of the PWM signal. Thus, the third switching element 54 is maintained in the conducting state over several cycles of the PWM signal (in line with the modification signal).

In the examples shown in Figure 7, the lower AGU voltage level and the higher AGU voltage level are modified depending on the modification signal. For example, the lower AGU voltage level is decreased from 60% of the unmodified higher AGU voltage level (which may be equal to the voltage of the power source 4) to 0 V. The higher AGU voltage level is decreased from the voltage of the power source 4 to the voltage of the unmodified or unchanged lower AGU voltage level.

This allows the power delivery to be controlled (reduced, increased) according to the value of the control signal without requiring the current waveform of the PWM signal to swing between the extreme values of maximum-to-zero in each PWM cycle. Instead, the current waveform amplitude can be reduced so as to swing between, for example, maximum-to-halfway, or halfway-to-minimum. Other amplitudes are possible by changing the resistances of the first resistor 56 and/or the second resistor 58.

Optionally, the first resistor 56 and/or the second resistor 58 are tuneable for changing the amplitude of the current waveform. To this end, the first resistor 56 and/or the second resistor 58 can be connected to the controller 25b which may be configured to automatically adjust the resistance values of the first resistor 56 and/or the second resistor 58. In this way, the controller 25b can automatically change both the switching signal as well as the amplitude of the power delivered to the aerosol-generating unit 2. This may allow a finer or more precise control of the power delivered to the aerosol-generating unit 2.

The technical benefit of this reduction in amplitude may be as follows.

The first switching element 50 may have relatively high self-capacitance. This means that reducing the amplitude of a PWM signal input to them reduces the time needed for the first switching element 50 to respond (i.e., charge/discharge) to the voltage/current swings of the signal within a cycle. It is also expected to provide a reduction in heating of the circuitry inherent in driving high-frequency AC signals through circuit components (e.g., first switching element 50) possessing high internal capacitances.

The method disclosed herein may also provide a new approach of controlling the energy delivered to a heating element which could complement the normal PWM techniques by allowing, in effect, an amplitude modulation in tandem with (or even in place of) pulse width modulation. Put in other words, the width of the pulses need not be modulated as much according to this disclosure.

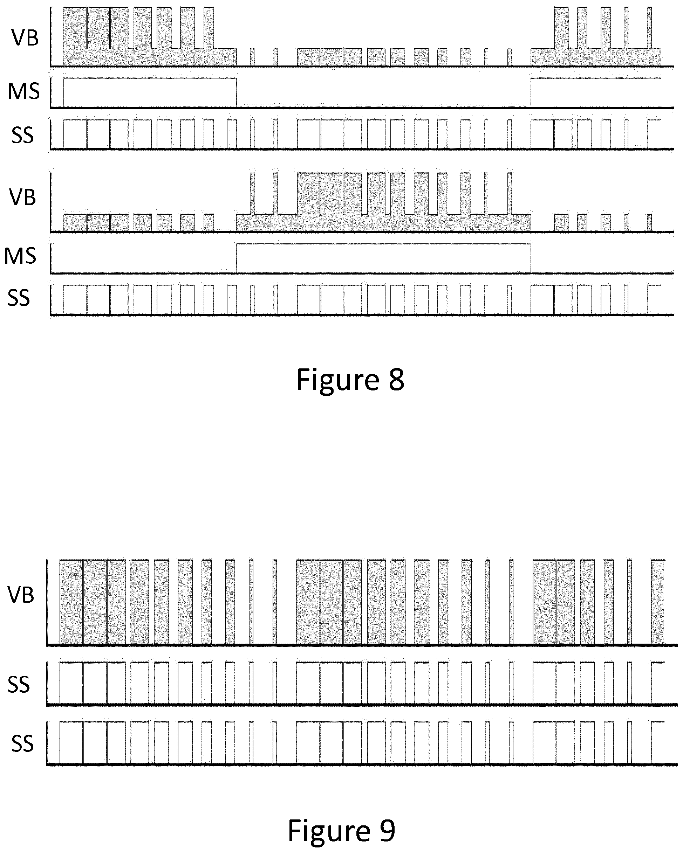

Figure 8 show the exemplary temporal behaviour of the voltage supplied to the aerosol-generating unit 2 (indicated as "VB") resulting from a switching signal (indicated as "SS") and a modification signal (indicated as "MS") for the second supply configuration described above (where the controller 25b is configured to supply the modification signal to the gate of the second switching element 52 and is configured to supply the switching signal to the gate of the third switching element 54 - not shown).

In the example shown in Figure 8, the lower AGU voltage level and the higher AGU voltage level are modified depending on the modification signal. For example, the lower AGU voltage level is decreased from 30% of the higher AGU voltage level (which may be equal to the voltage of the power source 4) to 0 V. The higher AGU voltage level is decreased from the voltage of the power source 4 to the voltage of the unmodified or unchanged lower AGU voltage level.

The modification of the lower AGU voltage level and the higher AGU voltage level may be achieved (in comparison to the example of Figure 7) by switching the supply of the switching signal and the modification signal between the second and third switching elements 52, 53 and/or by modifying the resistances of the first resistor 56 and/or the second resistor 58.

Figure 9 show the exemplary temporal behaviour of the voltage supplied to the aerosol-generating unit 2 (indicated as "VB") resulting from a switching signal (indicated as "SS") for the third supply configuration described above (where the controller 25b is configured to supply the switching signal to both the gate of the second switching element 52 and the gate of the third switching element 54).

Thus, for the example of Figure 9, unlike with the example of Figures 7 and 8, the modification signal is not supplied to the second switching element 52 or the third switching element 54. Rather, the switching signal (again a PWM signal which may be identical to the switching signals of Figures 7 and 8) is supplied to both the second switching element 52 and the third switching element 54.

In the example shown in Figure 9, the voltage supplied to the aerosol-generating unit 2 "VB" swings between the lower switching voltage level of 0 V and the upper switching voltage level which may be equal to the voltage of the power source 4. In this way, it possible to provide a regular PWM although the control circuit 25a includes a voltage divider.

In some examples, the controller 25b may be configured to switch between the first supply configuration, the second supply configuration and/or the third supply configuration, thereby allowing for further modifications in the lower AGU voltage level and/or the higher AGU voltage level.

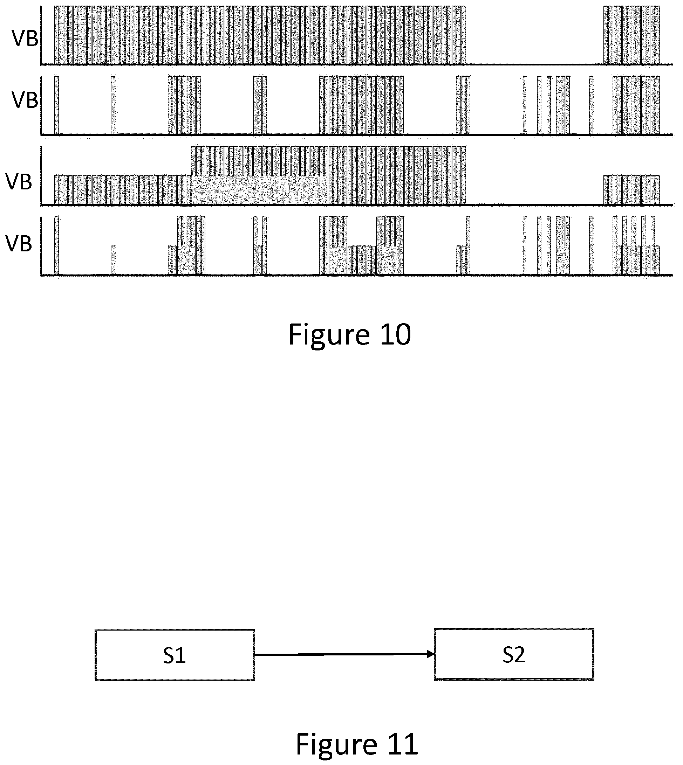

Figure 10 shows the exemplary temporal behaviour of the voltage supplied to an aerosol-generating unit (indicated as "VB") for a pulse-frequency modulation implementation.

The VB depicted in the first and second (upper) lines of Figure 10 switches between the higher AGU voltage level (which may correspond to the voltage of the power source 4) and the lower AGU voltage level (which may be 0 V). Thereby, the higher AGU voltage level corresponds to a fully conducting state of the first switching element 50 and the lower AGU voltage level corresponds to a non-conducting state of the first switching element 50. In other words, VB depicted in the first and second (upper) lines of Figure 10 show two different examples of conventional pulse frequency modulation.

In the third and fourth (lower) lines of Figure 10, the lower AGU voltage level and the higher AGU voltage level are modified using the first supply configuration described above in connection with the control circuit 25a of Figure 6. Thus, the control circuit 25a provides a modification of the first control voltage and the second control voltage for generating the changed lower AGU voltage level and the higher AGU voltage level shown in Figure 10. Thereby, the third row shows the same frequency modulation as the first row while the lower AGU voltage level and the higher AGU voltage level are modified. Similarly, the fourth row shows the same frequency modulation as the second row while the lower AGU voltage level and the higher AGU voltage level are modified.

A method for controlling the aerosol-generating unit 2 of an aerosol-generating system 1 will be explained in connection with Figure 11.

In step S1, the aerosol-generating unit is controlled by controlling the power supply from the power source 4 for to the aerosol-generating unit 2 using pulse width modulation and/or frequency modulation. Thereby, the switching signal is switched between the first voltage level and the second voltage level.

In step S2, the first voltage level and/or the second voltage level are changed or modified changing or modifying the higher AGU voltage level and/or the lower AGU voltage level that is supplied to the aerosol-generating unit 2.

## Claims

1. An electrical circuitry for controlling an aerosol-generating unit (2) of an aerosol-generating system (1),
wherein the electrical circuitry (25) is configured to be connected to the aerosol-generating unit (2) and to a power source (4) for powering the aerosol-generating unit (2),
wherein the electrical circuitry (25) is configured to implement pulse-width-modulation and/or frequency modulation by switching a voltage supplied to the aerosol-generating unit (2) between a lower AGU voltage level and a higher AGU voltage level,
wherein the electrical circuitry (25) includes:
a first switching element (50) configured to switch the voltage supplied to the aerosol-generating unit (2) between the lower AGU voltage level and the higher AGU voltage level depending on a control voltage, and
a control circuit (25a) for generating the control voltage to be supplied to the first switching element (50),
wherein the control circuit (25a) is configured, based on a switching signal of the pulse-width-modulation and/or frequency modulation, to switch between generating:
a first control voltage configured to control the first switching element (50) to supply the voltage of the lower AGU voltage level to the aerosol-generating unit (2), and
a second control voltage configured to control the first switching element (50) to supply the voltage of the higher AGU voltage level to the aerosol-generating unit (2), and
wherein the control circuit (25a) is further configured to change the first control voltage so as to modify the lower AGU voltage level supplied to the aerosol-generating unit (2) and/or the second control voltage so as to modify the higher AGU voltage level supplied to the aerosol-generating unit (2).

2. The electrical circuitry of claim 1, wherein one of the unchanged first control voltage and the changed first control voltage is configured to control the first switching element (50) to supply a lower AGU voltage level of 0 V to the aerosol-generating unit (2) and the other of the unchanged first control voltage and the changed first control voltage is configured to control the first switching element (50) to supply a lower AGU voltage level in range of 5 % to 75 % of a voltage of the power source (4) to the aerosol-generating unit (2).

3. The electrical circuitry of claim 1 or 2, wherein one of the unchanged second control voltage and the changed second control voltage is configured to control the first switching element (50) to supply a higher AGU voltage level corresponding to a voltage of the power source (4) to the aerosol-generating unit (2) and the other of the unchanged second control voltage and the changed second control voltage is configured to control the first switching element (50) to supply higher AGU voltage level in range of 40 % to 85 % of the voltage of the power source (4) to the aerosol-generating unit (2).

4. The electrical circuitry of claim 3, wherein the unchanged first control voltage is configured to control the first switching element (50) to supply the lower AGU voltage level of 0 V to the aerosol-generating unit (2), the unchanged second control voltage is configured to control the first switching element (50) to supply the higher AGU voltage level in range of 40 % to 85 % of the voltage of the power source (4) to the aerosol-generating unit (2), the changed first control voltage is configured to control the first switching element (50) to supply the lower AGU voltage level in range of 5 % to 75 % of the voltage of the power source (4) to the aerosol-generating unit (2), and the changed second control voltage is configured to supply the voltage of the power source (4) to the aerosol-generating unit (4).

5. The electrical circuitry of claim 3 or 4, wherein a difference between the lower AGU voltage level provided by the unchanged first control voltage and the higher AGU voltage level provided by the unchanged second control voltage is less than 60 % of the voltage of the power source (4) and 0 V and/or a difference between the lower AGU voltage level provided by the changed first control voltage and the higher AGU voltage level provided by the changed second control voltage is less than 60 % of the voltage of the power source (4) and 0 V.

6. The electrical circuitry of any one of the claims 3 to 5, wherein a first range between the lower AGU voltage level provided by the changed first control voltage and the higher voltage provided by the changed second control voltage does not overlap with a second range between the lower AGU voltage level provided by the unchanged first control voltage and the higher AGU voltage level provided by the unchanged second control voltage.

7. The electrical circuitry of any preceding claim, wherein the electrical circuitry (25) is configured to maintain the changed higher AGU voltage level and/or the changed lower AGU voltage level supplied to the aerosol-generating unit (2) over two or more cycles of the pulse-width-modulation and/or frequency modulation.

8. The electrical circuitry of any preceding claim, wherein the electrical circuitry includes
a controller (25b) for generating:
the switching signal of the pulse-width-modulation and/or frequency modulation, and
a modification signal which switches between an upper modification voltage level and a lower modification voltage level,
a second switching element (52), and
a third switching element (54) connected in parallel with the second switching element (52),
wherein the switching signal and the modification signal are used with the second switching element (52) and the third switching element (54) to generate the control voltage.

9. The electrical circuitry of claim 8, wherein the control circuit (25a) is configured to supply the switching signal to one of the second switching element (52) and the third switching element (54), and to supply the modification signal to the other one of the second switching element (52) and the third switching element (54) to generate the control voltage.

10. The electrical circuitry of claim 8 or 9, wherein the control circuit (25a) is configured to supply the switching signal simultaneously to the second and third switching elements (54) to generate the control voltage.

11. The electrical circuitry of any one of the claims 8 to 10, wherein the control circuit (25a) includes a first resistor (56) connected in series with the second switching element (52) and a second resistor (58) connected in series with the third switching element (54).

12. The electrical circuitry of claim 11, wherein the first resistor (56) and/or the second resistor (58) are tuneable.

13. The electrical circuitry of claim 12, wherein the controller (25b) is configured to tune the first resistor (56) and/or the second resistor (58) for changing levels of the first control voltage and/or the second control voltage.

14. An aerosol-generating system, comprising
an aerosol-generating unit (2) configured to generate an aerosol from an aerosol-forming material (10),
a power source (4) for powering the aerosol-generating unit (2), and
the electrical circuitry (25) of any preceding claim for controlling the generation of the aerosol.

15. A method for controlling an aerosol-generating unit (2) of an aerosol-generating system (1), comprising the steps of
controlling the aerosol-generating unit (2) by controlling a power supply from a power source (4) of the aerosol-generating system (1) to the aerosol-generating unit (2) using pulse-width-modulation and/or frequency modulation, the voltage of a cycle of the pulse-width-modulation and/or frequency modulation is switched between a first voltage level and a second voltage level, and
changing the first voltage level and/or the second voltage level unit during the pulse-width modulation and/or frequency modulation.
